# EUROPEAN PATENT APPLICATION

(11) **EP 2 487 732 A2**
(43) Date of publication of application: **15.08.2012**
(21) Application number: 12159073.1
(22) Date of filing: 11.02.2008
(51) Int. Cl.: H01L 41/113, H02N 2/18

(54) **Bistable piezoelectric generator**

(30) Priority: 15.02.2007 IT RM20070079
(62) Divisional of application: 08738422.8
(71) Applicant: Wisepower S.R.L., 05010 Fabro Scalo (TR) (IT)
(72) Inventor: Gammaitoni, Luca, 06134 Perugia (IT); Vocca, Helios, 06127 Perugia (IT); Amico, Paolo, 06123 Perugia (IT)
(74) Representative: Perronace, Andrea

(57) **Abstract**

The invention concerns a piezoelectric bistable generator comprising at least an elongated piezoelectric material element, with one end fixed at a base and having a first permanent magnet attached to the other end, said at least an piezoelectric material element being suited to bend so that it can assume two distinct stable equilibrium positions on the side of a central instable position in which it is disposed perpendicularly to the base. A second permanent magnet or electro-magnet is fixedly placed in front of the first permanent magnet. A fixed structure holds in place the second permanent magnet or electro-magnet with inverted magnetic polarity with respect to said first permanent magnet at due distance from the said first permanent magnet .

## Description

The present invention concerns a bistable piezoelectric generator.

More specifically, the invention concerns an electric power generator based on the conversion of mechanical energy into electric energy through the bistable oscillations of elements of piezoelectric material.

It is well known that the piezoelectric generators are commonly used in a number of fields of the human activity, in order to provide electric current by means of the conversion of mechanical energy. However, the limited quantity of electric energy produced by the conventional generators tends to limit their use. In recent years a number of studies have been proposed where the power generated by piezoelectric material could be employed to power mini and micro portable electronic devices. As a matter of fact, such devices during their operation need just a limited amount of electric power, allowing the use of power micro-generators that are an interesting alternative to the traditional batteries. In this perspective there have been proposed power micro-generators that can be connected to devices or structures undergoing some kind of movement (table vibrations, benches or mechanical structures vibrations, oscillatory motions made by machines or cars, human or animal motion, natural atmospheric or seismic event activated motion).

Such devices convert the energy present in the environment into electric energy that can be used to power electronic micro devices.

The main limitation of the existing devices however, is their intrinsic inability to exploit the whose wide spectrum of the energy available. This is due to the fact that their functioning principle unavoidably selects just a small portion of the whose wide energy spectrum.

The kinetic energy freely available in the environment (natural events, machine, animal or human related motion) is usually spread in a wide spectrum of frequencies ranging from few Hz to few KHz. The existing generators are based on the linear oscillations of mechanical piezoelectric structures.

By the moment that such structures, for geometrical reasons, oscillate mainly at their resonant frequency, they are capable of exploiting the environment energy only in a narrow frequency band, close to that resonant frequency.

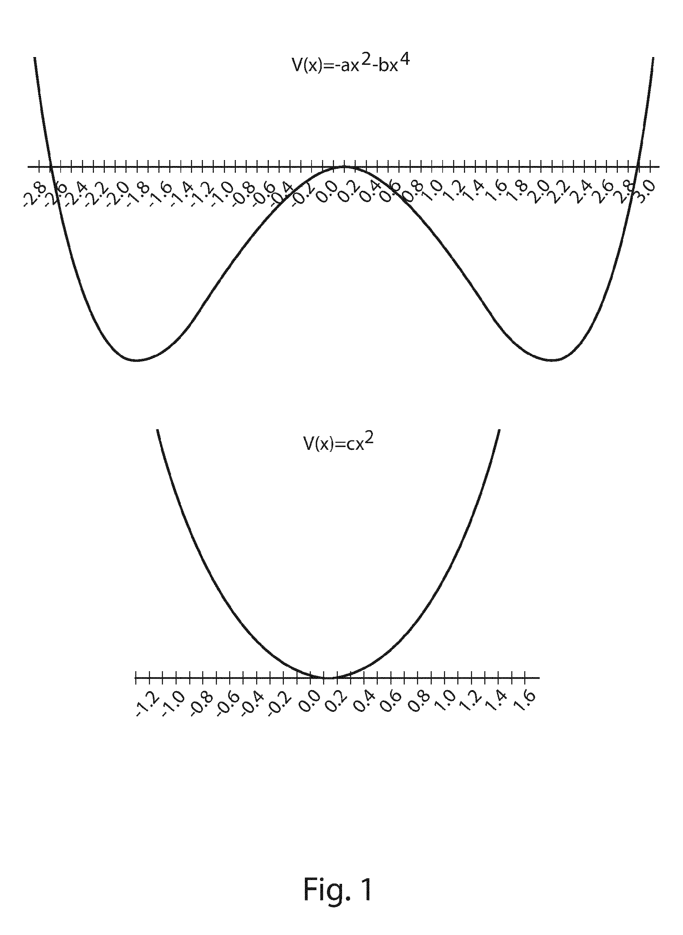

On the other hand, a bistable oscillator is a nonlinear oscillating system that, at difference with a linear one, admits two equilibrium positions (see graph in figure 1).

For the linear oscillator the oscillations are represented by periodic movements centered around the single equilibrium point. For the nonlinear bistable oscillator the oscillations are represented by a more complex motion. In addition to the two simple oscillations centered each around the local equilibrium point, in analogy with the linear oscillator, there are also wide movements that represents the passage from one equilibrium point to the other.

Based on these premises, the Applicant has realized a Bistable piezoelectric generator that is capable to overcome the above mentioned limitations of linear piezoelectric generators.

In the past a number of devices aimed at the same purposes of the present invention has already been proposed. Examples can be found in patents: U.S. n° 2,081,862 by Alfred L. W. Williams, 4,467,236 by Henry H. Kolm and Eric A. Kolm, 4,510,484 by D.S. Snyder, 4,504,761 by CG. Triplett, 5,512,795 by Michael Y. Epstein et al, 6,407,484 by John R. Oliver et al, 6,438,193 by W.H. Ko e 7057330 by Steven A. Buhler et al.

The solution proposed in the present invention provides an electric power generator based on the conversion of mechanical energy into electric energy obtained from the bistable motion of elements of piezoelectric material.

The converter, as in the invention, can be shaped in a number of different geometrical configurations, all based on the same conceptual principle: i.e. the bistable oscillations of a dynamical system.

It is the specific object of the present invention a bistable piezoelectric generator comprising at least one element in piezoelectric material, with at least one end fixed at a base and having the other end with a mass capable of making oscillations between two distinct positions, respectively a first equilibrium position and a second position opposed to the first, said at least one element being subjected to nonlinear bistable oscillations, the kinetic energy of such bistable oscillations being converted into electric energy and transformed through an electronic circuit in a suitable form for the powering of electric and/or electronic devices.

Possibly, according to the invention, said at least one piezoelectric element is a rod or a bar whose shape is approximately a parallelepiped.

In one form of realization of the bistable piezoelectric generator, according to the invention, the said mass is fixed at one end of said element of piezoelectric material opposed to the end fixed at the base. According to the invention, the generator can be realized with a plurality of piezoelectric elements, all with one end fixed at the same or separate base, and each of them with a separate or the same mass fixed at the other end. In this case the electric potential differences collected and transformed by an electronic circuit in a suitable form for the powering of electric and/or electronic devices.

In another realization, the bistable piezoelectric generator, according to the invention, said at least one piezoelectric element having both the ends fixed each at its own base, the mass positioned on the piezoelectric element in a position approximately centered on the element, between the two ends. According to the invention, the generator can be realized with a plurality of piezoelectric elements, all with both the ends fixed each at its own base, the mass positioned on the piezoelectric element in a position approximately centered on the element, between the two ends.

In another realization, the bistable piezoelectric generator, according to the invention, said at least one piezoelectric element with one end fixed at a base and having at the other end a permanent magnet, being present a fixed structure that, at due distance from the said magnet, holds in place another permanent magnet or an electro-magnet, with inverted magnetic polarities respect to the said permanent magnet at the end of the piezoelectric element. According to the invention, the generator can be realized with a plurality of piezoelectric elements, all with one end fixed at a base and having at the other end a permanent magnet.

Specifically, according to the invention, the generator can be realized with a plurality of piezoelectric elements, oriented in ordered or random way and electrically connected in series or in parallel with the nearby element.

According to the invention, said bistable piezoelectric generator, is based on the exploitation of the bistable oscillations of the dynamical system composed by the piezoelectric elements.

The present invention is described here, for illustration purposes but not limited to, following its preferred realization forms, with specific reference to the figures of the attached drawings, where:
Figure 1 shows two graphs of the potential energy function *V(x)* putting into evidence the difference between a linear oscillator (*V(x)* = *cx²*) and a nonlinear (nonlinear) oscillator (*V(x)* = -*ax²* + *bx⁴*);
Figure 2 shows a possible realization of the bistable piezoelectric generator according to the invention;
Figure 3 shows a second possible realization of the bistable piezoelectric generator;
Figure 4 shows a third possible realization of the bistable piezoelectric generator;
Figure 5 shows a fourth possible realization of the bistable piezoelectric generator;
Figure 6 shows a graph of the nonlinear potential *V(x)* = *-ax²* + *bx⁴* for different values of the parameter α, with fixed *b*;
Figure 7 shows a graph of the spectral density *S(f)* as a function of the parameter α*,* with fixed *b*; and
Figure 8 shows a graph of the power provided by the piezoelectric oscillator as a function of the parameter α, with fixed *b*.

By looking at the figures of the attached drawings, it is evident how the electric power generator can assume different geometric configurations all based on the very same invention principle of exploitation of the bistable oscillations of a dynamical system.

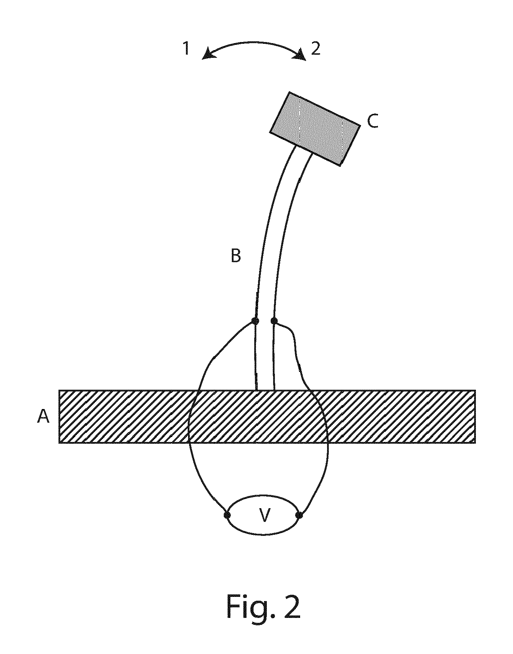

Starting with figure 2, a tiny rod B whose shape is approximately that of a parallelepiped, made of piezoelectric material, is hold in place in a fixed base at one end A, while at the other end is free and has attached a mass C that slightly bend the rod with its weight.

Vibrations and/or oscillations induced in the base A produce the oscillation of the mass C attached to the free end of the rod B, making it widely move between one equilibrium position 1 and the other opposite equilibrium position 2 in a truly bistable motion.

The repeated bending of the piezoelectric rod B produces at its terminal an electric potential difference V, which can be converted into an electricity flux (current) by using standard electronics, not discussed here by the moment that it is not specific of the invention.

The electric current thus generated can be usefully employed for the powering of electronic devices.

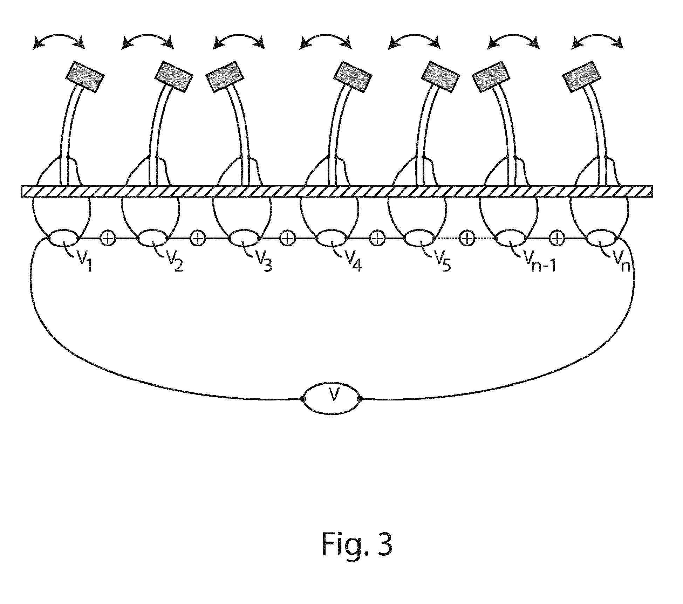

Coming now to figure 3, it is shown a possible realization of the bistable piezoelectric generator where a series of tiny rods B, whose shapes are each approximately that of a parallelepiped, made of piezoelectric material, are placed close to each other and are hold in place in a fixed base A at one end. The other end of each rod is free and has attached each a mass C that slightly bend the rods B with its weight. Vibrations and/or oscillations induced in the base A produce the oscillation of the masses C attached to the free ends of the rods B, making them widely move between one equilibrium position 1 and the other opposite equilibrium position 2 in a truly bistable motion. The repeated bending of the piezoelectric rods B produces at their terminal an electric potential difference V, V₂, ...Vₙ, which can be converted into an electricity flux (current) by using standard electronics, not discussed here by the moment that it is not specific of the invention. The electric current thus generated can be usefully employed for the powering of electronic devices.

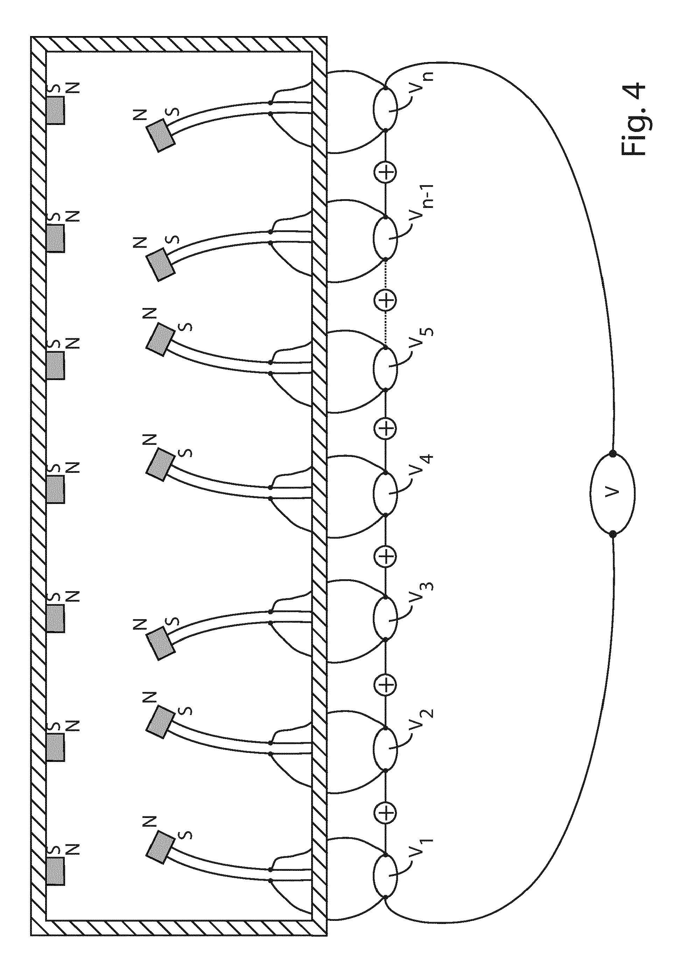

Coming to figure 4, a third possible realization of the bistable piezoelectric generator, according to the invention, where a series of tiny rods B, whose shapes are each approximately that of a parallelepiped, made of piezoelectric material, are placed close to each other and are hold in place in a fixed base A at one end. The other end of each rods is free and has attached a permanent magnet D (NS), being present a fixed structure F that, at due distance from the said magnets D, holds in place other permanent magnets E or an electro-magnets, with inverted magnetic polarities (SN) respect to the said permanent magnets D at the end of the piezoelectric element on every rods.

The whose of these magnets/electromagnets E is attached to the fixed structure F that is fixed rigidly to the base A. The force between the magnets D (or between these and the electromagnets E) induces the partial bending of each rod B. Vibrations and/or oscillations induced in the base A produce the oscillation of the masses (in this case the magnets D) attached to the free end of the rod B, making them widely move between one equilibrium position 1 and the other opposite equilibrium position 2 in a truly bistable motion.

The repeated bending of the piezoelectric rods B produces at their terminal an electric potential difference V, V₂, ...Vₙ, which can be converted into an electricity flux (current) by using standard electronics, not discussed here by the moment that it is not specific of the invention.

The electric current thus generated can be usefully employed for the powering of electronic devices.

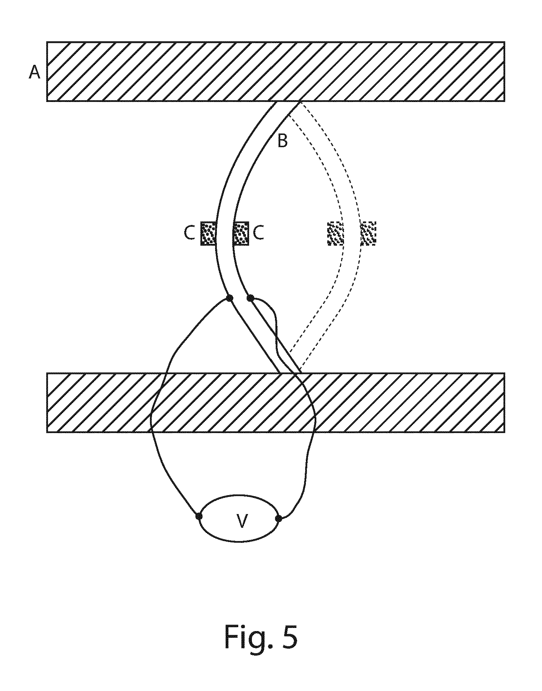

In figure 5 is shown a fourth possible realization of the bistable piezoelectric generator, according to the invention, where a tiny rod B, whose shape is approximately that of a parallelepiped, made of piezoelectric material, has each end connected to a rigid and fixed structure A, A' in such a way that the rod is slightly bended on one side. Approximately at the middle of the rod, between the two ends, a heavy mass C is attached. Vibrations and/or oscillations induced in the structure produce the oscillation of the mass C fixed at the middle of the rod B, making it widely move between one equilibrium position 1 and the other opposite equilibrium position 2 in a truly bistable motion. The repeated bending of the piezoelectric rod B produces at its terminal an electric potential difference V, which can be converted into an electricity flux (current) by using standard electronics, not discussed here by the moment that it is not specific of the invention.

The electric current thus generated can be usefully employed for the powering of electronic devices. This realization of the bistable piezoelectric generator can be made with an arbitrary number of piezoelectric rods B connected each other in a way analogous to that one of figure 3.

At the fundament of the bistable piezoelectric generator, according to the invention, there is the principle of conversion of the mechanical energy into electric energy through the piezoelectric effect. The current produced at the ends of the piezoelectric rods B, fixed other conditions, is larger the larger is the bending of the rod under the motion of the structure where this is connected. The current generated by the bistable piezoelectric generator, according to the invention, is thus a function of the motion of the rod B that in turn is a function of the motion of the structure A. For the same piezoelectric conversion factor, given two different piezoelectric generators, it will be more efficient the generator that is capable to respond with wider motion to the motion of the structure A where it is fixed. Such a capability-to-respond to a certain motion is quantified in the concept of response function.

The response function of a mechanical structure, like the piezoelectric rod B, determines what fraction of the energy provided by the environment is transferred to the mechanical structure.

The standard piezoelectric generators have a response function of resonant type, i.e. the maximum of the transferred energy is realized for a unique, specific frequency, called resonant frequency, that is typical of each structure. Far from this frequency the amount of energy transferred to the structure decreases rapidly and approximates to zero for frequencies of the order of two or three (or one half, one third) of the resonant frequency.

On the contrary, the bistable piezoelectric generator, according to the present invention shows a response function of NON-resonant type. In other words, for this response function, it does not exist just a unique resonance frequency, like in the linear oscillators, but the dynamics is instead characterized by a non-linear response function as in the bistable oscillator in the piezoelectric generator of the invention.

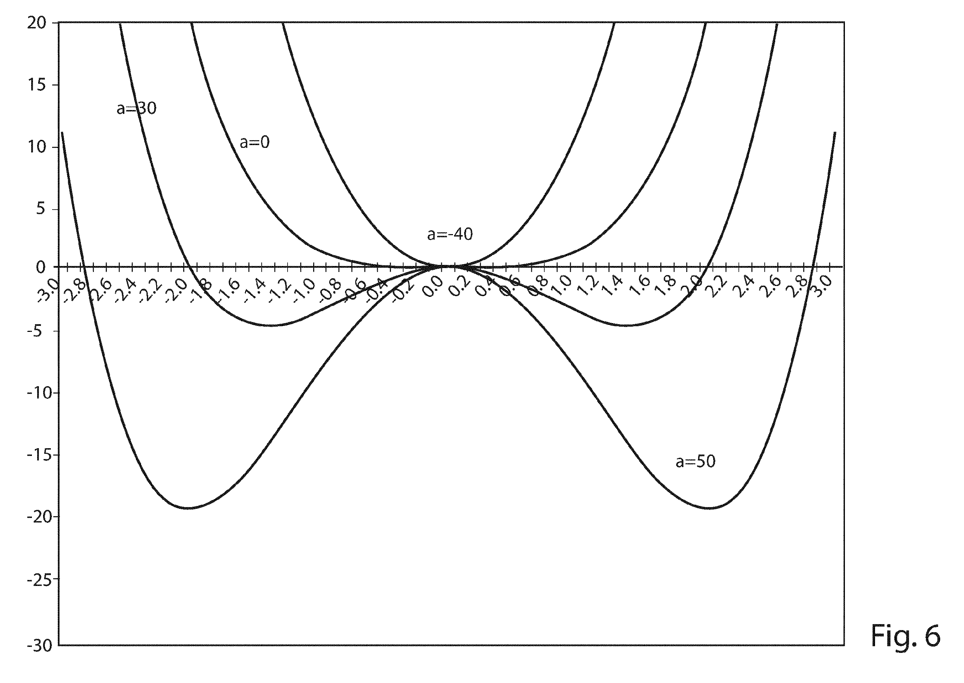

To better put into evidence the advantage of a nonlinear (bistable) response compared to a linear (resonant) response let's consider the mathematical function called Spectral Density Function *S(f).* The function *S(f)* describes the behavior of a generic dynamic system under the effect of an external force. If we imagine that the external force is made by the environment vibrations that give the mechanical energy to the piezoelectric generator, then the efficiency of the generator can be measured by the area under the curve of *S(f)* as a function of *f*. Such an area is proportional to the electric power produced by the piezoelectric generator. Let's consider a dynamic system made by a oscillator with a bistable potential energy function (see figure 1) as defined by equation *V(x)* = *-*α*x²* + *bx⁴.* This potential is characterized by two parameters, α and *b* whose value can be varied at will. By keeping fixed the value *b* and changing the value a (see figure 6), we can go from the monostable potential configuration (quasi-linear, resonant case) for α<0 to the bistable potential configuration (non-linear, NON resonant case) for α>0.

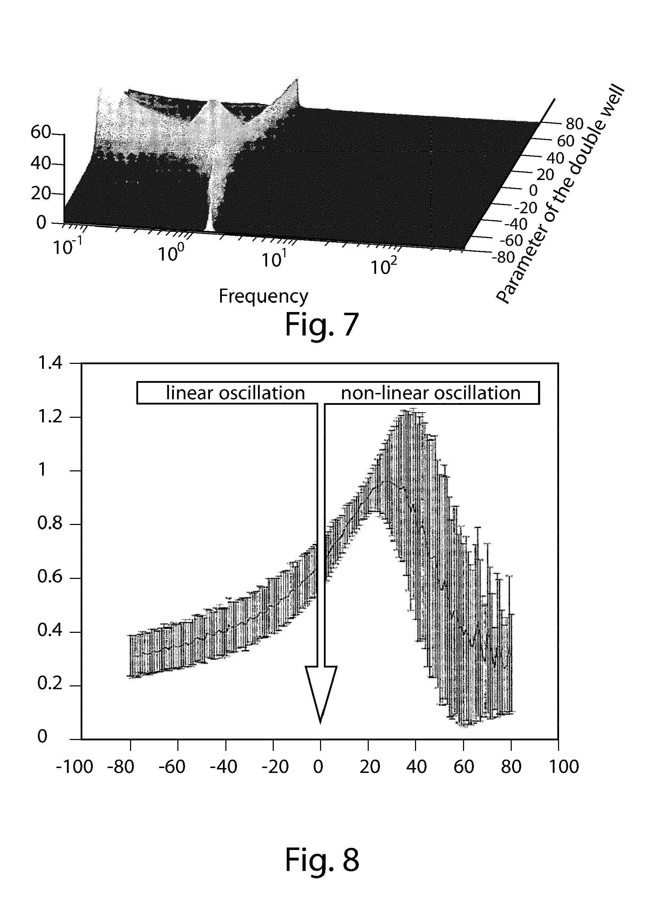

In figure 7 we show the function *S(f)* as a function of the frequency *f* for different values of the parameter α. For every fixed value a we have a different function *S(f)*. The area under the curve *S(f)* (i.e. the integral of the function *S(f)* between 0 and +∞) is a measure of the power obtainable. Such quantity is shown in figure 8, as a function of the parameter α. As it is well apparent, it does exist an optimal value of the parameter α, where the obtainable power reaches a maximum. Such an optimal value of a is in the bistable potential configuration region.

The present invention has been described with illustrative but not limitative purpose, acconding to its preferred potential realization configurations. It is understood that variations and/or modifications could be applied without for this reason leaving the invention protection domain as defined in the attached claim list.

## Claims

1. Piezoelectric bistable generator comprising at least an elongated piezoelectric material element, with one end fixed at a base and having a first permanent magnet attached to the other end, **characterised in that** said at least an piezoelectric material element is suited to bend so that it can assume two distinct stable equilibrium positions on the side of a central instable position in which it is disposed perpendicularly to the base, **characterised in that** a second permanent magnet or electro-magnet is fixedly placed in front of the first permanent magnet, being present a fixed structure that, at due distance from the said first permanent magnet, holds in place the second permanent magnet or electro-magnet with inverted magnetic polarity with respect to said first permanent magnet.

2. Piezoelectric bistable generator according to claim 1, **characterized by** the fact that at least one said element is of piezoelectric material and is a rod or a bar whose shape is approximately a parallelepiped.

3. Piezoelectric bistable generator according to claim 1 o 2, **charaeterized in that** it comprises a plurality of piezoelectric material elements with respective first permanent magnets and corresponding second permanent magnets or electro-magnets, the various electrical potential differences of every element being collected and transformed by an electronic circuit in a suitable form for the powering of electric and/or electronic devices.

4. Piezoelectric bistable generator according to claim 3, **characterized in that** the elements of the plurality of piezoelectric material elements are oriented in ordered or random way and electrically connected in series or in parallel with the nearby element.
